(19) **Europäisches Patentamt**

**European Patent Office**

**Office européen des brevets**

(11) **EP 1 097 385 B1**

(12) **EUROPÄISCHE PATENTSCHRIFT**

(45) Veröffentlichungstag und Bekanntmachung des Hinweises auf die Patenterteilung:
**18.12.2002 Patentblatt 2002/51**

(51) Int Cl.⁷: **G01R 15/06**

(21) Anmeldenummer: **99934616.6**

(22) Anmeldetag: **07.07.1999**

(86) Internationale Anmeldenummer:
**PCT/EP99/04772**

(87) Internationale Veröffentlichungsnummer:
**WO 00/005589 (03.02.2000 Gazette 2000/05)**

(54) **KAPAZITIVER SPANNUNGSTEILER ZUR MESSUNG VON HOCHSPANNUNGSIMPULSEN MIT MILLISEKUNDEN-IMPULSDAUER**

CAPACITATIVE VOLTAGE DIVIDER FOR MEASURING HIGH VOLTAGE PULSES WITH A MILLISECOND PULSE DURATION

DIVISEUR DE TENSION CAPACITIF POUR MESURER DES IMPULSIONS HAUTE TENSION D'UNE DUREE DE L'ORDRE DE LA MILLISECONDE

(84) Benannte Vertragsstaaten:
**CH DE DK FR GB LI**

(30) Priorität: **23.07.1998 DE 19833179**
**20.05.1999 DE 19923211**

(43) Veröffentlichungstag der Anmeldung:
**09.05.2001 Patentblatt 2001/19**

(73) Patentinhaber: **Forschungszentrum Karlsruhe GmbH**
**76133 Karlsruhe (DE)**

(72) Erfinder:
- **KUPERMAN, Grigory**
 **D-76149 Karlsruhe (DE)**
- **JÜNGST, Klaus-Peter**
 **D-76297 Stutensee (DE)**
- **SALBERT, Heinrich**
 **D-66793 Saarwellingen (DE)**

(56) Entgegenhaltungen:
**DD-A- 220 704**          **US-A- 3 011 123**

**Beschreibung**

Die Erfindung betrifft einen kapazitiven Spannungsteiler zur Messung von Hochspannungsimpulsen mit Millisekunden-Impulsdauer.

Zum Messen von Hochspannungsimpulsen im Nano- und Mikrosekundenbereich werden einfache kapazitve Spannungsteiler verwendet. Der Hochspannungsteiler eines solchen besteht meist aus mindestens einem zylindrischen Kondensator, der sich in einem unter Druck stehenden Isoliergas oder Isolieröl befindet. Der Niederspannungsteil des Hochspannungsteilers kann in Abhängigkeit vom geforderten Teilerverhältnis K im selben Raum wie der Hochspannungsteil (etwa K < 100) oder getrennt davon (etwa K > 100) aufgebaut sein. Mit serienmäßig gefertigten Kondensatoren ist der Spannungsteiler in der einen oder andern Art standardmäßig aufgebaut.

Bei räumlich getrennter Bauweise des kapazitiven Spannungsteilers in den Hochspannungs- und Niederspannungsteil entstehen während des Einsatzes häufig Veränderungen bei den Kapazitäten durch die Erwärmung des Dielektrikums, wohingegen sich das Verhältnis der Kapazitäten $C_1/C_2$ bei Kapselung in einem gemeinsamen Dielektrikum praktisch nicht ändert, also $C_1/C_2$ konstant bleibt. Der Meßfehler kann bei Temperaturänderung durchaus bis zu einigen Prozent betragen. Dieses Problem der temperaturabhängigen Kapazität kann also durch Vermeidung des räumlich getrennten Aufbaus weitestgehend unwirksam gemacht werden.

Aus der Literatur ist ein kapazitiver Spannungsteiler bekannt (G. Kuperman et al. "Hochleistungs-Präzisions-Impulsmodulator mit einer Kunstleitung in den Variometern", Akademie der Wissenschaften der UdSSR, Versuchseinrichtungen und -technik, Band 3, Moskau 1985), dessen Hochspannungsteiler aus einer Kaskade von in Reihe geschalteten Kondensatoren C1 und C2 besteht. Die Kondensatoren C1 und C2 befinden sich alle in Transformatoröl, wodurch der o. e. Temperatureffekt nicht zum Tragen kommt. Der Meßspannungsteiler besteht aus zwei in Reihe liegenden Kondensatoren C3 und C4, der am potentialmäßig hochliegenden Kontakt des Kondensators C2 kontaktiert. Das Potential zwischen den beiden Kondensatoren C3 und C4 wird zum Meßinstrument mit dem Eingangswiderstand R2, ein Oszilloskop z. B., geführt. Ist die Kapazität des Niederspannungsteils C2 am Hochspannungsteiler erheblich größer als die Kapazität des oben liegenden Kondensators C3 im Meßspannungsteiler, also C3 « C2, dann ergibt sich ein Teilerverhältnis

$$K \approx ((C2 + C3)*C4)/(C1*C3).$$

Der derartig aufgebaute Hochspannungsteiler ist einfach, zuverlässig und hat eine große Temperaturstabilität. Er ist zur Messung von Hochspannungsimpulsen der Dauer im Mikrosekunden- und Nanosekundenbereich geeignet, so jedoch nicht mehr zur Messung im Millisekundenbereich, da am Ende eines 1,5 msec-Pulses z. B. der Meßfehler bis zu 15 % und mehr betragen kann - das ist unannehmbar.

Aus der DE 41 40 506 A1 ist ein Hochspannungsabtastkopf mit großem Frequenzbereich bekannt. Die Meßeinrichtung besteht aus einem kapazitiven Spannungsteiler aus einer Hochspannungskaskade und einer Meßkaskade von Kondensatoren, wobei die Meßkaskade am tiefsten liegenden Kondensator der Hochspannungskaskade abgreift, wie auch das Spannungssignal am tiefsten liegenden Kondensator der Meßkaskade dem Meßinstrument zugeführt wird. Ein den hochliegenden Kondensator in der Meßkaskade überbrückender Widerstand hat, um einen optimalen Abschluß für das Koaxialkabel zu erreichen, denselben Widerstand wie dessen Wellenwiderstand, nämlich 50 $\Omega$. Dieser derartig dimensionierte Widerstand hat reine Abschlußfunktion für die Signalleitung. Die Abweichungen des damit erhaltenen Meßsignals vom wahren, proportional zum Hochspannungsimpuls heruntergeteilten Signals sind insbesondere im msec-Bereich erheblich und für Steuer- und Überwachungszwecke nicht mehr brauchbar.

Aus der US 3 011 123 ist ein kapazitiver Spannungsteiler bekannt, bei dem ein verstellbarer Widerstand den hochliegenden Kondensator des Meßspannungsteilers überbrückt.

Die Aufgabe, die der Erfindung zugrunde liegt, ist das präzise Messen des zeitlichen Verlaufes von Hochspannungsimpulsen mit Impulsdauern im Millisekundenbereich.

Diese Aufgabe wird durch einen kapazitiven Spannungsteiler gemäß dem Oberbegriff und dem kennzeichnenden Merkmal des Anspruchs 1 gelöst. Der aus dem Stand der Technik bekannte, für den Nanound Mikrosekundenbereich geeignete kapazitive Spannungsteiler wird wegen seiner Einfachheit und Zuverlässigkeit beibehalten und durch eine schaltungstechnisch einfache Maßnahme mit geringem Aufwand für größere Zeitfenster modifiziert. Das Ziel, auch Hochspannungsimpulse mit Impulsdauern im Millisekundenbereich präzise zu messen, wird durch die Parallelschaltung eines ohmschen Widerstands R1 zum Kondensator C3 und dessen geeignete Dimensionierung erreicht. Dabei ist die Dimensionierung derart, daß gilt:

$$1,1 < C4R2/C3R1 < 1,15.$$

Durch diese Maßnahme wird die Genauigkeit der Spannungsmessung bei einer Impulsdauer im Millisekundenbereich von derzeit etwa + 7.5% je nach Bauteiledimensionierung bis auf ± 0,02% unter Einhaltung der Temperaturstabilität der nach heutigem Stand der Technik gebauten kapazitiven Hochspannungsteiler verbessert.

Der repräsentative Widerstand R2 ist in seinen möglichen schaltungstechnischen Aufbauten gekennzeichnet. Sie orientieren sich an der meßtechnischen Notwendigkeit. Der letzte Teil des Kennzeichens führt dabei auch eine schaltungstechnische Maßnahme zum Unterdrücken von unerwünschten Schwingungen während eines schnellen Spannungsanstiegs des Hochspannungsimpulses auf, nämlich das Vorschalten eines ohmschen Widerstandes R3 in Verbindung mit einer Kaxialleitung im Abgang zum Meßinstrumenteneingang (Anspruch 2).

Im Unteranspruch 3 ist gekennzeichnet, daß sich die Hochspannungskaskade bis zumindest dem potentialmäßig am tiefsten liegenden Kondensator in einem Dielektrikum befindet, um dann in den Unteransprüchen 4 bis 6 jeweils die gängige technische Kapselung bzw. das umhüllende Dielektrikum der Kaskade des Hochspannungsteilers zu kennzeichnen. Flüssig oder gasförmig kann es bei kompakter Bauweise und hoher notwendiger Spannungsfestigkeit unter Druck gesetzt sein.

Der Vorteil eines derartig aufgebauten Spannungsteilers besteht darin, daß im ersten Moment nach Anlegen eines rechteckigen Hochspannungsimpulses die Spannung am Eingang des Meßinstruments oder Meßverstärkers durch das Verhältnis der Kapazitäten im Hochspannungsteiler bestimmt wird. Die Genauigkeit der Messung der Spannung am Ende des Rechteckimpulses mit Millisekundendauer wird durch die Dimensionierung des Widerstandes über dem hochliegenden Kondensator im Meßspannungsteiler um Größenordnungen verbessert.

Die Erfindung wird anhand eines Durchführungsbeispiels und in Anlehnung der Zeichnung näher erläutert. Es zeigt:

Figur 1 den für den Millisekunden-Impulsdauer modifizierten kapaziven Spannungsteiler,
Figur 2 den bekannten kapazitiven Spannungsteiler für Impulsdauern im Nano- und Mikrosekunden-Bereich,
Figur 3 den zeitlichen Verlauf der Spannung am Oszilloskop beim Anlegen eines rechteckigen Hochspannungsimpulses an den optimierten Spannungsteiler.

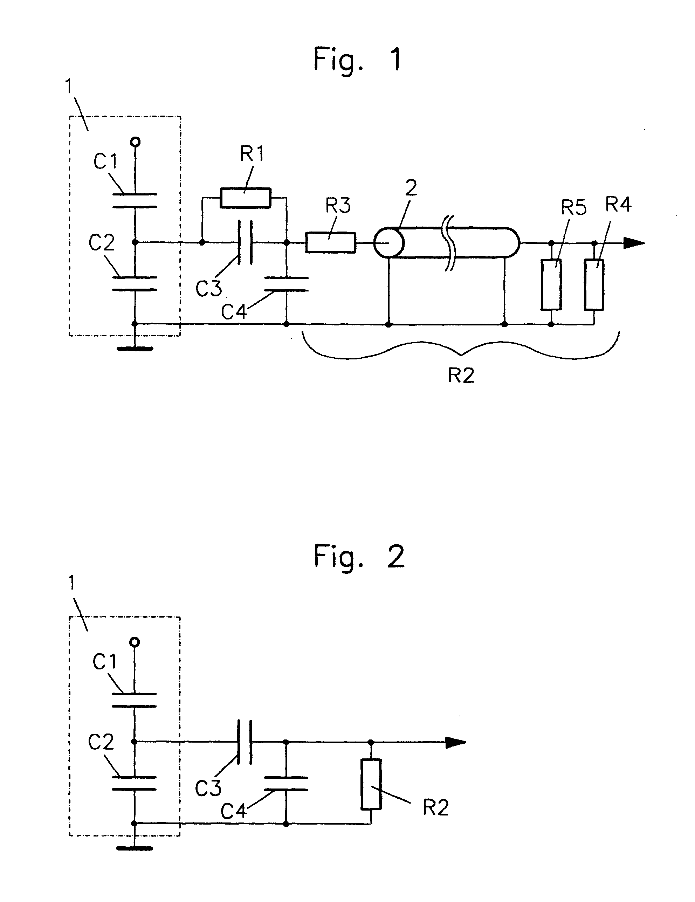

Der Hochspannungsteil C1 (Figur 1) des Hochspannungsteilers besteht aus einem oder je nach Spannungsfestigkeit aus mindestens zwei in Reihe geschalteten Kondensatoren C1, der oder die sich üblicherweise in einem unter Druck stehenden Isoliergas oder Isolieröl wie Transformatoröl oder sonstwie geeigneter Isoliermedien befindet oder befinden. Der Niederspannungsteil C2 ist beispielsweise ein Plattenkondensator, der im selben Raum wie der Hochspannungsteil C1 untergebracht ist. Damit besteht für die Kaskade C1, C2 des Hochspannungsteilers überall eine Umgebung gleicher Temperatur, womit der Temperatureinfluß neutralisiert ist.

Der Meßspannungsteiler besteht aus einer Kaskade aus hintereinander geschalteten, serienmäßig gefertigten Kondensatoren C3 und C4, die an dem gemeinsamen Potentialpunkt von C1 und C2 und am Bezugs - hier Erdpotential - wie der Hochspannungsteiler endet.

Der Spannungsteiler besteht prinzipiell aus dem klassischen, für Nano- und Mikrosekunden-Impulsdauern geeigneten, rein kapazitiven Spannungsteiler gemäß Figur 2 und lediglich der Parallelschaltung des Widerstands R1 (Korrekturwiderstand) zu C3. Dabei wird der überbrückende Widerstand R1 so dimensioniert, daß das Verhältnis des Produkts aus der Kapazität des Kondensators C4 des Meßspannungsteilers C3C4 und dem repräsentativen Widerstand R2 zu dem Produkt aus der Kapazität des Kondensators C3 am Messpannungsteiler C3C4 und des überbrückenden Widerstands R1 zwischen 1,1 und 1,15 liegt, also

$$1,1 < (C4 \times R2)/(C3 \times R1) < 1,15,$$

wobei der repräsentative Widerstand R2 auch eine Parallelschaltung aus dem Eingangswiderstand des Meßinstruments und dem dazu parallel geschalteten Korrekturwiderstand R5 sein kann.

Der Spannungsteiler wird im folgenden analytisch näher betrachtet, um seine Tauglichkeit und Vorzüge deutlich aufzuzeigen. Hierzu sei noch kurz auf den realen Aufbau der Messung eingegangen, um die Parameterbildung transparent zu machen: Die Kapazität von C4 repräsentiert genaugenommen die Kapazität des unteren Meßspannungsteilers C3, C4 und die Kapazität des Koaxialkabels 2 sowie des Meßintrumenten- bzw. hier des Oszilloskopeingangs. Die parallen Widerstände R5, ebenfalls ein Korrekturwiderstand zwecks einfacher Abstimmbarkeit des Spannungsteilers und zur gleichzeitigen Erhöhung der Meßgenauigkeit, und R4 als Eingangswiderstand des Oszilloskops sowie der serielle Widerstand R3 zur Dämpfung von Schwingungen bei schnellen Spannungsänderungen, wie der Anstiegsflanke beim Rechteck, sind durch den Widerstand R2 repräsentiert. Die angelegte Hochspannung hat rechteckigen Verlauf, sie springt auf 100kV und verharrt so lange auf diesem Niveau, daß die Anstiegs- und Abfallzeit als Null betrachtet werden kann.

Im Komplexen ergibt sich nun eine Spannung der Form

$$U(p) = (a + bp)/(p^2 + mp + n)$$

mit

$$a = 10^5 Cl/[R1C3(C4 + C1 + C2) + R1C4(C1 + C2)],$$

$$b = 10^5 ClC3/[C3(C4 + C1 + C2) + C4(C1 + C2)],$$

$$m = [R1(C1 + C2 + C3) + R2(C1 + C2 + C4)]/\{R1R2[C3(C4 + C1 + C2) +$$

$$C4(C1 + C2)]\},$$

$$n = 1/\{R1R2[C3(C4 + C1 + C2) + C4(C1 + C2)]\}.$$

Zurück in den Zeitbereich, ergibt die Spannung

$$U(t) = e^{-\alpha t} (a - b\alpha)/(\beta - \alpha) - e^{-\beta t} (a - b\beta)/(\beta - \alpha),$$

mit

$$\alpha = 0{,}5m - (0{,}25m^2 - n)^{0{,}5}$$

und

$$\beta = 0{,}5m - (0{,}25m^2 - n)^{0{,}5}$$

Darüber läßt sich für die Auslegung der Bauteile beispielsweise folgender Dimensionierungssatz ermitteln:

$$C1 = 12{,}4 \times 10^{-12} \ F,$$

$$C2 = 900 \times 10^{-12} \ F,$$

$$C3 = 94 \times 10^{-12} \ F,$$

$$C4 = 22{,}8 \times 10^{-9} \ F,$$

$$R1 = 84 \times 10^6 \ \Omega$$

und

$$R2 = 385{,}4 \times 10^3 \ \Omega.$$

Der zeitliche Spannungsverlauf am Ausganng des Spannungsteilers hat für dieses Dimemsionierungsbeispiel folgenden optimalen zeitlichen Verlauf:

$$U(t) = 5{,}71 * e^{-11{,}79t} - 0{,}69 * e^{-112{,}9t} \quad .$$

Es tritt ein Maximum auf. Die beste Annäherung (Tschebyscheff-Approximation) an den eigentlich konstanten Spannungsverlauf ist erreicht, wenn:

- sich das Maximum innerhalb des Zeitintervalls der Pulsdauer befindet und

die Werte zu Beginn und am Ende des gemessenen Impulses gleich sind.

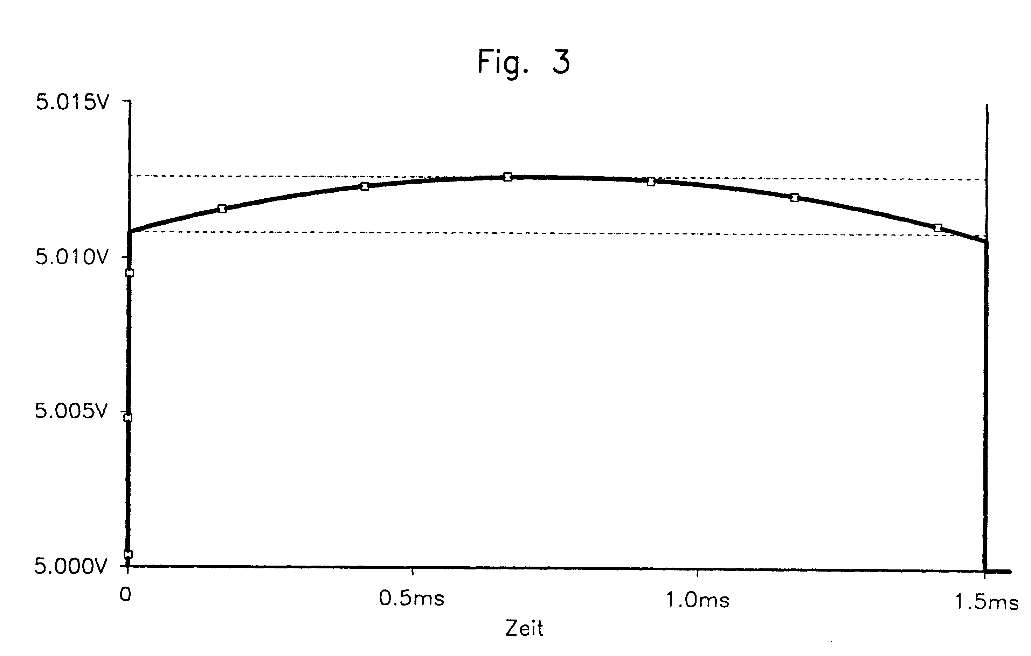

Figur 3 zeigt den zeitlichen Verlauf der Meßspannung am Oszilloskop, die am gemäß den oben angegebene Werten dimensionierten Spannungsteiler abgegriffen wurde. Die Pulsdauer von 1,46 msec führt zu dem geforderten optimalen Ergebnis. Der Fehler ist nicht größer als ± 0,02%. Nach dem Stand der Technik beträgt der Fehler 15% (± 7,5%). Das ist eine Verbesserung um mehr als zwei Größenordnungen.

Die Spannung am Eingang des Oszilloskops kann zum Zeitpunkt des Endes des für die Zeitverhältnisse rechteckigen Eingangspulses durch die Dimensionierung so eingestellt werden, daß sie gleich der zu Beginn des Impulsanfangs ist. Weiter wird die Form des gemessenen Impulsdaches am Oszilloskops bei angelegtem rechteckigen Hochspannungsimpuls nicht hauptsächlich durch die Zeitkonstante R2C4 bestimmt (R2 ist der zum Kondensator C4 parallel liegende Ersatzwiderstand, der den Widerstand aus Koaxialkabel 2 zum Meßinstrument und dessen Eingangswiderstand R4 repräsentiert). Vielmehr ergibt sich die Impulsform aus den Verhältnissen der Kapazitäten der Kondensatoren und dem Verhältnis der Widerstände (R1/R2). Dies ist von Bedeutung für die Genauigkeit, da die Zeitkonstante R2C4 im allgemeinen nicht groß genug gewählt werden kann.

In der folgenden Tabelle sind Beispiele für kapazitive Spannungsteiler zur Messung von Hochspannungsimpulsen mit Millisekunden-Impulsdauer aufgeführt.

Tabelle

| Lfd Nr. | C1 pF | C2 nF | C3 pF | C4 nF | R1 MΩ | R2* kΩ | $\tau_1$ ** ms | $\tau_2$ *** ms | $\tau_2$ ***/ $\tau_1$ ** | $\tau_1$ ms | δu % |
|---|---|---|---|---|---|---|---|---|---|---|---|
| 1 | 12,4 | 0,9 | 94 | 22,8 | 84 | 385,4 | 7,896 | 8,787 | 1,113 | 1,5 | ±0,018 |
| 2 | 14,26 | 0,9 | 94 | 26,22 | 84 | 335,13 | 7,896 | 8,78 | 1,112 | 1,5 | ±0,014 |
| 3 | 6,0 | 0,04 | 47 | 11,4 | 159 | 741 | 7,473 | 8,45 | 1,131 | 3,6 | ±0,1 |
| 4 | 15 | 0,9 | 94 | 27,2 | 200 | 770 | 18,8 | 20,94 | 1,114 | 4,0 | ±0,02 |
| 5 | 15 | 0,9 | 96 | 27,3 | 210,4 | 830 | 20,2 | 22,66 | 1,122 | 6,2 | ±0,95 |
| 6 | 12,4 | 0,9 | 94 | 22,8 | 159 | 741 | 14,9 | 16,89 | 1,134 | 7,2 | +0,1 |
| 7 | 12,4 | 0,9 | 94 | 22,8 | 170,5 | 800 | 16,027 | 18,24 | 1,138 | 10 | ±0,02 |

R2* = R4*R5/(R4+R5)

$\tau_1$** = R1*C3

$\tau_2$*** = R2*C4

Normalerweise beträgt für die Überwachung von Impulsspannungen höher als 100 kV an Klystronen oder Magnetronen die Kapazität des Hochspannungskondensators C1 etwa 6 bis 15 pF. Die Eingangskapazität des elektronischen Meßinstruments, z. B. ein Oszilloskop, beträgt üblicherweise 20 bis 30 pF und der Eingangswiderstand 1 MΩ. Die Kapazität des Kabels ist in der von C4 mit enthalten. Hier wird von einem 50 Ω-Koaxkabel ausgegangen, das bis zu 100 m lang sein kann. Aus der Tabelle wird die Wirkung der Dimensionierung ersichtlich: die Spannungsschwankung während des Impulsdaches hält sich bei Beachtung der vorgegebenen Bauteile-Dimensionierung in den Grenzen ± 0,1%.

Die Dimensionierung der Kapazität der Kondensatoren im Spannungsteiler wird durch das geforderte Teilerverhältnis K bestimmt. Damit kann nur noch der Wert des Widerstands R1 im Meßspannungsteiler C3, C4 und repräsentative Eingangswiderstand R2 der am Meßspannungsteiler angeschlossenen Einrichtung zur Darstellung der Meßspannung frei gewählt werden. Durch die geeignete Auswahl derselben wird mit dem modifizierten kapazitiven Spannungsteiler eine Verbesserung der Meßgenauigkeit um 2 bis 3 Größenordnungen gegenüber dem derzeitigen Stand der Technik erreicht, wobei die Temperaturstabilität aufrecht erhalten bleibt.

Die prinzipielle schaltungstechnische Maßnahme ist mit einem fast unerheblichen Aufwand verbunden und läßt sich durch andere Dimensionierung auf andere Zeitfenster im Millisekundenbereich übertragen. Ergänzende, nicht maßgebende Verbesserungen lassen sich durch die Beschaltung des Koaxialkabels 2 mit den Widerständen R3 (Schwingungdämpfung im raschen Spannungsanstieg) und R5 (Abgleich der Zuleitung zum Meßinstrument) erreichen, das ist insbesondere für eine stationäre Meßeinrichtung eine übliche Maßnahme.

**Bezugszeichenliste:**

| | |
|---|---|
| 1 | dielektrisches Medium |
| 2 | Koaxialkabel |
| C1 | Kondensator |
| C2 | Kondensator |
| C3 | Kondensator |
| C4 | Kondensator |
| R1 | Widerstand |
| R2 | Widerstand |
| R3 | Widerstand |
| R4 | Eingangswiderstand |
| R5 | Korrekturwiderstand |

**Patentansprüche**

1. Kapazitiver Spannungsteiler zum Messen von Hochspannungsimpulsen mit Millisekunden-Impulsdauer, bestehend aus:

   einem Hochspannungsteiler aus einer Kaskade von mindestens zwei in Reihe zueinander geschalteten Kondensatoren, wobei ein erster Kondensator (C1) den potentialmäßig hochliegenden Teil und ein zweiter Kondensator (C2) den potentialmäßig tiefliegenden Teil des Hochspannungsteilers, an dem zur Messung abgegriffen wird, repräsentiert,
   einem an den zweiten Kondensator (C2) gekoppelten Meßspannungsteiler aus einer Kaskade von mindestens zwei in Reihe zueinander geschalteten weiteren Kondensatoren, wobei ein dritter Kondensator (C3) den potentialmäßig hochliegenden Teil und ein viertert Kondensator (C4) den potentialmäßig tiefliegenden Teil des Meßspannungsteilers, an dem zur Messung abgegriffen wird, repräsentiert,
   einem den dritten Kondensator (C3) überbrückenden ohmschen ersten Widerstand (R1) und
   einem repräsentativen zweiten Widerstand (R2), der den vierten Kondensator (C4) überbrückt und den Eingangswiderstand der ankoppelnden Meßeinrichtung darstellt,

   **dadurch gekennzeichnet, daß**
   der erste Widerstand (R1) so dimensioniert ist, daß das Verhältnis des Produkts aus der Kapazität C4 des vierten Kondensators (C4) und dem Widerstandswert R2 des zweiten Widerstands (R2) zu dem Produkt aus der Kapazität C3 des dritten Kondensators (C3) und dem Widerstandswert R1 des ersten Widerstands (R1) größer als 1 ist, und zwar

$$1{,}1 < C4R2/C3R1 < 1{,}15.$$

2. Spannungsteiler nach Anspruch 1,
   **dadurch gekennzeichnet, daß**
   die Meßeinrichtug ein Meßinstrument aufweist und daß der zweite Widerstand (R2) repräsentativ für:

   den Eingangswiderstand (R4) des Meßinstruments oder
   eine Parallelschaltung aus einem Korrekturwiderstand (R5) und dem Eingangswiderstand (R4) des Meßinstruments oder
   einen Längswiderstand (R3) mit einer Koaxialleitung (2), die der Parallelschaltung vorgeschaltet sind,

   steht.

3. Spannungsteiler nach Anspruch 2,

**dadurch gekennzeichnet, daß**
sich der ersten Kondensator (C1) des Hochspannungsteilers oder der gesamte Hochspannungsteiler mit ersten und zweiten Kondensator (C1, C2) in einem unter Druck oder nicht unter Druck stehenden dielektrischen Medium (1) befindet.

**4.** Spannungsteiler nach Anspruch 3,
**dadurch gekennzeichnet, daß**
das dielektrische Medium (1) Öl ist.

**5.** Spannungsteiler nach Anspruch 3,
**dadurch gekennzeichnet, daß**
das dielektrische Medium (1) Isoliergas ist.

**6.** Spannungsteiler nach Anspruch 3,
**dadurch gekennzeichnet, daß**
das dielektrische Medium (1) Gießharz ist.


**Claims**

**1.** Capacitive voltage divider for measuring high-voltage pulses with a millisecond pulse duration, comprising:

a high-voltage divider formed from a cascade of at least two capacitors which are connected in series with each other, a first capacitor (C1) representing the high potential part, and a second capacitor (C2) representing the low potential part of the high-voltage divider, at which the pick-up operation is effected for the measurement, a measuring voltage divider, which is connected to the second capacitor (C2) and comprises a cascade of at least two additional capacitors, which are connected in series with each other, a third capacitor (C3) representing the high potential part, and a fourth capacitor (C4) representing the low potential part of the measuring voltage divider, at which the pick-up operation is effected for the measurement, a first ohmic resistance (R1) which bridges the third capacitor (C3), and a representative second resistance (R2), which bridges the fourth capacitor (C4) and represents the input resistance of the measuring device being connected thereto,

**characterised in that**
the first resistance (R1) is so dimensioned that the ratio between the product of the capacitance C4 of the fourth capacitor (C4) and
the resistance value R2 of the second resistance (R2) and the product of the capacitance C3 of the third capacitor (C3) and the resistance value R1 of the first resistance (R1) is greater than 1, namely

$$1.1 < C4R2/C3R < 1.15.$$

**2.** Voltage divider according to claim 1, **characterised in that** the measuring means includes a measuring instrument, and **in that** the second resistance (R2) is representative of:

the input resistance (R4) of the measuring instrument, or
a parallel circuit comprising a correction resistance (R5) and the input resistance (R4) of the measuring instrument, or
a series resistance (R3) with a coaxial line (2), which precedes the parallel circuit.

**3.** Voltage divider according to claim 2, **characterised in that** the first capacitor (C1) of the high-voltage divider or the entire high-voltage divider with first and second capacitors (C1, C2) is situated in a pressurised or non-pressurised dielectric medium (1).

**4.** Voltage divider according to claim 3, **characterised in that** the dielectric medium (1) is oil.

**5.** Voltage divider according to claim 3, **characterised in that** the dielectric medium (1) is insulating gas.

**6.** Voltage divider according to claim 3, **characterised in that** the dielectric medium (I) is casting resin.

**Revendications**

**1.** Diviseur de tension capacitif pour mesurer les impulsions de haute tension d'une durée de l'ordre de la milliseconde comprenant :

- un diviseur de haute tension formé d'une cascade d'au moins deux condensateurs branchés en série, un premier condensateur (C1) représentant la partie de niveau haut du point de vue du potentiel et un second condensateur (C2) représentant celui situé en bas selon l'échelle des potentiels dans le diviseur de haute tension sur lequel on effectue des mesures.
- un diviseur de tension de mesure couplé au second condensateur (C2) et formé d'une cascade d'au moins deux autres condensateurs branchés en série l'un par rapport à l'autre, un troisième condensateur (C3) représentant une troisième partie à haute tension et un quatrième condensateur (C4) représentant la partie la plus basse du produit du potentiel du diviseur de tension de mesure sur laquelle on prend les mesures,
- une troisième résistance ohmique ayant une troisième valeur de résistance (R1), et chevauchant le troisième condensateur (C3), et
- une seconde résistance représentative (R2) qui court-circuite le quatrième condensateur (C4) et représente la résistance d'entrée de l'installation de mesure couplée,

**caractérisé en ce que**
la première résistance (R1) est dimensionnée pour que le rapport du produit de la capacité (C4) du quatrième condensateur (C4) et de la valeur R2 de la seconde résistance (R2) par rapport au produit de la capacité C3 du troisième condensateur (C3) et de la valeur de résistance R1 la première résistance externe (R1) est supérieur à 1 et répond à la double inégalité suivante :

$$1,1 < C4R2/C3R1 < 1,15.$$

**2.** Diviseur de tension selon la revendication 1,
**caractérisé en ce que**
l'installation de mesure comporte un instrument de mesure et la seconde résistance (R2) est représentative de :

- la résistance d'entrée (R4) de l'instrument de mesure ou,
- un circuit en parallèle formé d'une résistance de correction (R5) de la résistance d'entrée (R4) de l'installation de mesure, ou
- une résistance longitudinale (R3) avec une ligne coaxiale (2) branchée en amont du montage en parallèle.

**3.** Diviseur de tension selon la revendication 2,
**caractérisé en ce que**
le premier condensateur (C1) du diviseur de haute tension ou l'ensemble du diviseur de haute tension avec le premier et le second condensateurs (C1, C2) se trouve dans un milieu diélectrique (1) mis en pression ou sans pression.

**4.** Diviseur de tension selon la revendication 3,
**caractérisé en ce que**
le milieu diélectrique (1) est de l'huile.

**5.** Diviseur de tension selon la revendication 3,
**caractérisé en ce que**
le milieu diélectrique (1) est un gaz isolant.

**6.** Diviseur de tension selon la revendication 3,
**caractérisé en ce que**
le milieu diélectrique (1) est une résine coulée.

## Fig. 1

## Fig. 2

Fig. 3